# EUROPÄISCHE PATENTSCHRIFT

(11) **EP 0 277 283 B1**
(45) Veröffentlichungstag und Bekanntmachung des Hinweises auf die Patenterteilung: **31.03.1993**
(21) Anmeldenummer: 87115779.8
(22) Anmeldetag: 27.10.1987
(51) Int. Cl.: G01R 33/00, A61B 5/04

(54) **Biomagnetische Messeinrichtung**
Biomagnetic measuring device
Dispositif de mesure biomagnétique

(30) Priorität: 09.12.1986 DE 3641934
(43) Veröffentlichungstag der Anmeldung: 10.08.1988
(73) Patentinhaber: SIEMENS AKTIENGESELLSCHAFT, 80333 München (DE)
(72) Erfinder: Schneider, Siegfried, Dr., D-8520 Erlangen (DE)

(56) Entgegenhaltungen:
- IEEE TRANSACTIONS ON BIOMEDICAL ENGINEERING, Band BME-22, Nr. 3, Mai 1975, Seiten 167-174, IEEE, New York, US; A. ROSEN et al.: "Study of the vector magnetocardiographic waveform"
- IEEE TRANSACTIONS ON BIOMEDICAL ENGINEERING, Band BME-29, Nr. 1, Januar 1982, Seiten 16-25, IEEE, New York, US; T. KATILA et al.: "Magnetic measurement of cardiac volume changes"
- IEEE TRANSACTIONS ON MAGNETICS, Band MAG-13, Nr. 1, Januar 1977, Seiten 354-357, New York, US; J.P. WIKSWO Jr. et al.: "Application of superconducting magnetometers to the measurement of the vector magnetocardiogram"
- ELEKTROTECHNIK, Band 63, Nr. 24, 21. Dezember 1981, Seiten 24,25, Würzburg, DE; W. BAIER: "Lässt Hirnströme am Magnetfeld messen"
- IEEE TRANSACTIONS ON MAGNETICS, Band MAG-18, Nr. 1, Januar 1982, Seiten 260-270, IEEE, New York, US; V.O. KELHÄ et al.: "Design, construction, and performance of a large-volume magnetic shield"

## Beschreibung

Die Erfindung betrifft eine biomagnetische Meßeinrichtung mit einem in einer magnetisch schirmenden Kammer angeordneten Meßkryostaten und einer in der Kammer dem Meßkryostaten zugeordneten Patientenliege, wobei der Boden der Kammer über eine Halterung starr mit einem Fundamentsockel mit großer Masse verbunden ist und Aussparungen aufweist.

Eine biomagnetische Meßeinrichtung ist in dem Aufsatz "A Study of the Vector Magnetocardiographic Waveform" von A. Rosen/G. Inouye, erschienen in "IEEE Transactions on Biomedical Engineering", Vol. BME-22, No. 3, Mai 1975, New York, auf den Seiten 167 bis 173 abgebildet und beschrieben. Mit der Meßeinrichtung können Magnetocardiogramme (MCG) erstellt werden. Der Patient wird liegend untersucht ohne eine zusätzliche Abschirmkammer. Dazu sind ohne eine zusätzliche Abschirmkammer eine Patientenliege und die ein supraleitendes Gradiometer umfassende Meßeinrichtung getrennt auf einer Meßplattform angeordnet. Die Störunterdrückung dieser Meßeinrichtung ist jedoch nicht für alle biomagnetischen Messungen ausreichend.

Eine biomagnetische Meßeinrichtung der eingangs genannten Art ist aus dem Aufsatz "Läßt Hirnströme am Magnetfeld messen" von Dr. W. Baier in "elektrotechnik", Band 63, Nr. 24 Dezember 81, Würzburg, Seiten 24 bis 25 bekannt. Die dort beschriebene Meßeinrichtung ist auch in dem Aufsatz "The Berlin Magnetically Shielded Room, Section A: Design and Construction" von A. Mager aus "Biomagnetism", 1981, Verlag Walter de Gruyter & Co., Berlin, Seiten 51-78, bekannt. Die biomagnetische Meßeinrichtung umfaßt danach eine Umhüllung aus mehreren Schichten Mumetall. Der Boden der Umhüllung oder Kammer ist fest mit einem Fundament oder Sockel verbunden. Ein Trittboden ist über Säulen, die durch Aussparungen durch den Boden der Meßkammer geführt sind, in dem Fundament verankert. In dem erstgenannten Artikel ist auch eine Patientenliege und ein Meßkryostat in der Kammer dargestellt. Die genaue Anordnung der Patientenliege und des Meßkryostaten in der Kammer ist jedoch den beiden Artikeln nicht zu entnehmen, insbesondere befinden darin keine Angaben, wie der Meßkryostat vor Schwingungen geschützt werden kann.

Es ist z.B. aus "IEEE Transactions on Magnetics", Band MAG-13, No. 1, Jan. 1977, Seiten 354-377, in dem Artikel von J. P. Wikswo Jr. / W. M. Fairbanks mit dem Titel "Application of Superconducting Magnetometers to the Measurement of the Vector Magnetocardiogram" angegeben, daß es bei Bewegungen, insbesondere Erschütterungen außerhalb der Kammer oder bei Bewegungen des Patienten auf der Patientenliege zu Schwingungen am Meßkryostaten kommt, die das Meßergebnis verfälschen. Eine Auslenkung der Meßspule in Meßkryostaten, die als SQUID ausgebildet ist schon um wenige µm beeinträchtigt das Meßergebnis wesentlich, da die Meßspule dann neben den Signalen aus dem Körper des Patienten auch Störsignale registriert. Diese Störsignale werden verursacht durch Bewegungen von Meßspulen und Patent relativ zueinander oder durch Bewegungen der Meßspule und des Magnetfeldes der Umgebung relativ zueinander. Ein Meßkryostat der hier betrachteten Art ist beispielsweise aus der Veröffentlichung "Biomagnetismus, Signale aus dem Körper" von J. Hohnstein in "Bild der Wissenschaft" 1986, Band. 8, Seite 79, bekannt.

Es wurden in den letzten Jahren verschiedene Lösungsmöglichkeiten vorgeschlagen, um die Meßeinrichtung vor Schwingungen zu schützen. Eine besonders befriedigende Lösung blieb jedoch aus.

Aus dem Aufsatz "Design, Construction and Performance of a Large-Volume Magnetic Shield" von V. O. Kelhä et al. in, "IEEE Transactions on Magnetics", Vol. MAG-18, No. 1, Januar 1982, New York, Seiten 260 bis 270, ist z.B. eine Abschirmkammer bekannt, die als Ganzes auf Betonklötzen aufgestellt ist. Verschiebungen der Kammer sowie von innerhalb der Kammer verursachte Schwingungen (z.B. wenn der Patient oder der Arzt sich bewegt) werden durch diese Lösung nicht ausgeschaltet.

Aus dem oben zitierten Wiskwo/Fairbanks-Artikel ist bekannt, die Patientenliege federnd aufgehängen. Damit werden die vom Herzrhythmus induzierten Bewegungen der Patientenliege entkoppelt und Verzerrungen des magnetischen Feldes, die von diesen Bewegungen verursacht werden, vermieden.

Weiterhin ist aus dem Artikel "Installation of a Biomagnetic Measurement Facility in a Hospital Environment" von C. Bercy et al. erschienen in "Biomagnetism" 1981, Verlag Walter de Gruyter & Co., Berlin, Seiten 95 bis 106, ein magnetisch abgeschirmter Raum bekannt, der über Dämpfungsglieder am Fundament abgestützt ist. Ein solches elastisch gelagertes System bringt im Bereich der Resonanzfrequenz Wo eine Überhöhung von Schwingungen und im Bereich oberhalb der √2-fachen Resonanzfrequenz eine Reduktion von Schwingungen mit sich. Sehr niedrige, zur Zeit erreichbare Resonanzfrequenzen liegen im Bereich zwischen 1 und 5 Hz. Dadurch kann es aufgrund von Frequenzanteilen durch äußere Erschütterungen oder aufgrund von Anregungen durch Bewegungen des Patienten selbst, wie z.B. durch die Herztätigkeit oder die Atemtätigkeit zu einer Schwingungsüberhöhung bei niedrigen Frequenzen kommen.

Bei einer dämpfenden Lagerung allein des Meßkryostaten ist zu berücksichtigen, daß dieser dicht oberhalb des Patienten angeordnet ist. Bei Defekt der Dämpfungselemente, z.B. Pneumatikdämpfern, setzt der Meßkryostat, der mit flüssigem Helium gefüllt ist, mit seinem dünnwandigen Boden auf dem Patienten auf. Dieses birgt erhebliche Gefahren für den Patienten in sich.

Die Erfindung geht aus von der Überlegung, daß Anregungen aufgrund von Erschütterungen oder durch den Patienten selbst in ihrer Wirkung erheblich reduziert werden können, wenn sie über eine große Masse auf den Meßkryostaten übertragen werden.

Aufgabe der Erfindung ist es, eine biomagnetische Meßeinrichtung der eingangs genannten Art so auszubilden, daß Erschütterungen außerhalb der Meßeinrichtung oder durch den Patienten selbst hervorgerufene Schwingungen möglichst ohne Einfluß auf den Meßkryostaten bleiben.

Diese Aufgabe wird erfindungsgemäß dadurch gelöst, daß der Meßkryostat und die Patientenliege getrennt über eine erste bzw. zweite Anzahl Pfosten, die durch die Aussparungen geführt sind, fest am Fundamentsockel befestigt sind.

Durch diese Maßnahme wird erreicht, daß Bewegungen des Patienten zwangsläufig auf den Fundamentsockel, der in der Regel zwischen 10 und 20 Tonnen wiegt, übertragen und von dort auf den Meßkryostaten weitergeleitet werden. Das heißt, die Herz- und/oder Atembewegung des Patienten muß erst eine Masse von mehreren Tonnen anregen und in Bewegung setzen, bevor es zu einem nennenswerten Einfluß auf die Ruhelage des Meßkryostaten kommen kann. Auch andere innere oder äußere mechanische Störungen, z.B. durch Straßenverkehr hervorgerufen, können nur über Anregung der schweren Masse des Fundamentsockels auf den Meßkryostaten übertragen werden. Da eine solch schwere Masse nur schwer anzuregen ist, ergibt sich ein entsprechend kleiner Einfluß am Meßkryostaten (z.B. SQUID-System).

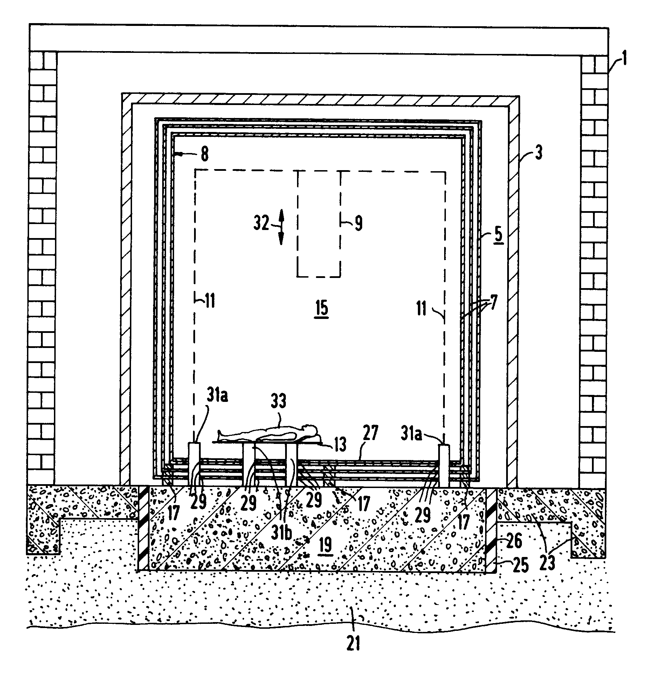

Weitere Vorteile und Ausgestaltungen der Erfindung ergeben sich aus der Beschreibung eines Ausführungsbeispiels an Hand der Figur. Die Figur zeigt eine biomagnetische Meßeinrichtung mit einem Meßkryostaten und einer Patientenliege zur Messung von Strömen in einem Patienten.

In einer Halle 1 befindet sich, von einer Außenwand 3 umgeben eine biomagnetische Meßeinrichtung 5. Die Außenwand 3 ist beispielsweise gemauert, aus Rigips®-Platten oder aus schalldämmendem Material gefertigt und dient vornehmlich dazu, die Meßeinrichtung 5 von außen vor Vibration und mechanischer Beschädigung zu schützen.

Die Meßeinrichtung 5 umfaßt mehrere Wände oder Schichten 7 aus einem Mumetall, die eine Kammer oder ein Gehäuse 8 bilden, einen Meßkryostaten 9, der über dem Patienten an einem Stativ 11 aufgehängt ist, und eine Patientenliege 13. Das Gehäuse 8 umschließt einen Meßraum 15, der durch die Mumetallbleche magnetisch gut abgeschirmt ist. Das Gehäuse 8 ist über eine oder mehrere Halterungen 17 möglichst starr mit einem schweren Fundamentsockel 19 verbunden. Dessen Masse kann 10 bis 20 Tonnen betragen. Er kann insbesondere aus eisenlosem Beton bestehen.

Der quaderförmige Fundamentsockel 19 ist auf ein Sandbett 21 gesetzt. Die Halle 1 weist ein Hallenfundament 23 mit Bodenplatte auf, die durch einen Zwischenraum 25 mechanisch von dem Fundamentsockel 19 getrennt sind. Der Zwischenraum 25 kann dabei mit einem Kunststoffschaum 26 ausgefüllt sein. Durch diese Maßnahme ist sichergestellt, daß mechanische Schwingungen von außerhalb der Halle 1, die beispielsweise durch den Straßenverkehr hervorgerufen werden, nicht direkt auf den Fundamentsockel 19 übertragen werden.

Das Gehäuse 8 weist eine Bodenplatte 27 auf, die auf der ersten Schicht 7 angebracht ist. Die bodenseitigen Schichten 7 und die Bodenplatte 27 weisen eine Anzahl an Löchern oder Aussparungen 29 auf, durch welche jeweils ein Pfosten 31a, 31b hindurchgeführt ist. Die Pfosten 31a, 31b sind aus einem elektrisch isolierenden Material, wie beispielsweise Holz, Keramik oder Kunststoff gefertigt. Sie sind mit ihrem unteren Ende jeweils fest mit dem Fundamentsockel 19 verankert und dienen als Verbindungseinrichtungen.

Auf einer ersten Anzahl der Pfosten, nämlich auf den Pfosten 31a, ist oben das Stativ 11 befestigt und auf einer zweiten Anzahl der Pfosten, nämlich auf den Pfosten 31b, ist die Patientenliege 13 befestigt oder gelagert. Der Meßkryostat 9 ist oberhalb der Patientenliege 3 in einem gewissen Bereich in der Höhe einstellbar. Dies ist durch einen Doppelpfeil 32 gekennzeichnet. Bewegungen des Patienten 33, der auf der Patientenliege 13 ruht, müssen erst über die zweiten Pfosten 31b auf den Fundamentsockel 19 geleitet werden, bevor sie von dort über die ersten Pfosten 31a auf das Stativ 11 übertragen werden können.

Aufgrund der großen Masse des Fundamentsockels 9 sind damit Bewegungen am Stativ 11 und am dort aufgehängten Meßkryostaten 9 weitgehend unterdrückt. Ebenso sind Schwingungen, die auf die Bodenplatte 27 des Meßraums 15 ausgeübt werden, beispielsweise durch einen anwesenden Arzt, nur über die Masse des Fundamentsockels 19 auf den Meßkryostaten 9 übertragbar. Um eine Übertragung dieser Schwingungen von der Bodenplatte 27 auf die Schichten 7 zu vermeiden, wäre es von Vorteil, die Bodenplatte 27 ebenfalls über eine dritte Anzahl von Pfosten direkt mit dem Fundament zu verbinden. Hierdurch wird eine sehr hohe Unempfindlichkeit der Meßeinrichtung 5 gegenüber mechanischen Störungen erzielt.

## Patentansprüche

1. Biomagnetische Meßeinrichtung (5) mit einem in einer magnetisch schirmenden Kammer (8) angeordneten Meßkryostaten (9) und einer in der Kammer (8) dem Meßkryostaten (9) zugeordneten Patientenliege (13), wobei der Boden (7) der Kammer (8) über eine Halterung (17) starr mit einem Fundamentsockel (19) mit großer Masse verbunden ist und Aussparungen (29) aufweist, **dadurch gekennzeichnet,** daß der Meßkryostat (9) und die Patientenliege (13) getrennt über eine erste bzw. zweite Anzahl von Pfosten (31a bzw. 31b), die durch die Aussparungen (29) geführt sind, fest am Fundamentsockel (19) befestigt sind.

2. Meßeinrichtung nach Anspruche 1, **gekennzeichnet durch** eine sie umgebende Halle (1), deren Hallenfundamente (23) vom Fundamentsockel (19) getrennt sind.

3. Meßeinrichtung nach Anspruch 1 oder 2, **dadurch gekennzeichnet,** daß der Fundamentsockel (19) auf einem Sandbett (21) gelagert ist.

4. Meßeinrichtung nach Anspruch 2 oder 3, **dadurch gekennzeichnet,** daß der Raum (25) zwischen dem Fundamentsockel (19) und dem Hallenfundament (23) mit einem Kunststoffschaum (26) ausgefüllt ist.

5. Meßeinrichtung nach einem der Ansprüche 1 bis 4, **dadurch gekennzeichnet,** daß die Pfosten (31a,31b) aus einem elektrisch isolierenden Material bestehen.

6. Meßeinrichtung nach einem der Ansprüche 1 bis 5, **dadurch gekennzeichnet,** daß der Meßkryostat (9) über ein Stativ (11) und die Verbindungseinrichtung (31a) am Fundamentsockel (19) befestigt ist.

7. Meßeinrichtung nach einem der Ansprüche 1 bis 6, **dadurch gekennzeichnet,** daß der Meßkryostat (9) oberhalb der Patientenliege (13) höhenverschiebbar ist.

8. Meßeinrichtung nach einem der Ansprüche 1 bis 7, **dadurch gekennzeichnet,** daß die Meßeinrichtung (5) mit einer Außenwand (3) aus schalldämmendem Material versehen ist.

9. Meßeinrichtung nach einem der Ansprüche 1 bis 8, **gekennzeichnet durch** eine Bodenplatte (27), die über eine Anzahl dritter Pfosten mit dem Fundament verbunden ist.

## Claims

1. Biomagnetic measuring installation (5) having a measuring cryostat (9) arranged in a magnetically shielded chamber (8) and a patient support table (13) assigned to the measuring cryostat (9) in the chamber (8), whereby the floor (7) of the chamber (8) is rigidly connected by way of a mounting support (17) to a foundation base (19) with a large mass and has recesses (29), characterised in that the measuring cryostat (9) and the patient support table (13) are firmly secured separately to the foundation base (19) by way of a first and a second number of posts (31a and 31b respectively), which are guided by way of the recesses (29).

2. Measuring installation according to claim 1, characterised by a room (1) surrounding it, the foundations (23) of this room being separated from the foundation base (19).

3. Measuring installation according to claim 1 or 2, characterised in that the foundation base (19) is seated on a sand bed (21).

4. Measuring installation according to claim 2 or 3, characterised in that the space (25) between the foundation base (19) and the room foundation (23) is filled with a plastics foam (26).

5. Measuring installation according to one of claims 1 to 4, characterised in that the posts (31a, 31b) consist of an electrically insulating material.

6. Measuring installation according to one of claims 1 to 5, characterised in that the measuring cryostat (9) is secured by way of a stand (11) and the connecting device (31a) is secured to the foundation base (19).

7. Measuring installation according to one of claims 1 to 6, characterised in that the measuring cryostat (9) can be displaced vertically above the patient support table (13).

8. Measuring installation according to one of claims 1 to 7, characterised in that the measuring installation (5) is provided with an outer wall (3) made of a sound-damping material.

9. Measuring installation according to one of claims 1 to 8, characterised by a floor plate (27) which is connected to the foundation by way of a number of third posts.

## Revendications

1. Dispositif de mesure biomagnétique (5) comportant un cryostat de mesure (9) disposé dans une chambre (8) formant écran magnétique, et une couchette pour patient (13) associée au cryostat de mesure (9) dans la chambre (8), le sol (7) de la chambre (8) étant relié rigidement, par l'intermédiaire d'un support (17), à un socle de fondation (19) possédant une masse importante, et comportant les ouvertures (29), caractérisé par le fait que le cryostat de mesure (9) et la couchette pour le patient (13) sont fixés séparément au socle de fondation (19) par l'intermédiaire d'un premier et d'un second nombres de poteaux (31a ou 31b), qui traversent les ouvertures (29).

2. Dispositif de mesure suivant la revendication 1, caractérisé par une salle (1) entourant ce dispositif et dont la fondation (23) est séparée du socle de fondation (19).

3. Dispositif de mesure suivant la revendication 1 ou 2, caractérisé par le socle de fondation (19) est disposé sur un lit de sable (21).

4. Dispositif de mesure suivant la revendication 2 ou 3, caractérisé par le fait que l'espace (25) situé entre le socle de fondation (19) et la fondation (23) de la salle est rempli par une mousse en matière plastique (26).

5. Dispositif de mesure suivant la revendication 1 à 4, caractérisé par le fait que les poteaux (31a,31b) sont réalisés en un matériau électriquement isolant.

6. Dispositif de mesure suivant l'une des revendications 1 à 5, caractérisé par le fait que le cryostat de mesure (9) est fixé au moyen d'un statif (11) et d'un dispositif de raccordement (31a) au socle de fondation (19).

7. Dispositif de mesure suivant l'une des revendications 1 à 6, caractérisé par le fait que le cryostat de mesure (9) est réglable en hauteur au-dessus de la couchette pour patient (13).

8. Dispositif de mesure suivant l'une des revendications 1 à 7, caractérisé par le fait que le dispositif de mesure (5) est pourvu d'une paroi extérieure (3) formée d'un matériau insonorisant.

9. Dispositif de mesure suivant l'une des revendications 1 à 8, caractérisé par une plaque de base (27), qui est reliée à la fondation par l'intermédiaire d'un certain nombre de troisièmes poteaux.
